Europäisches Patentamt

European Patent Office

Office européen des brevets

(11) Publication number: **0 398 039**
**A2**

## EUROPEAN PATENT APPLICATION

(21) Application number: **90107642.2**

(22) Date of filing: **23.04.90**

(51) Int. Cl.⁵: **H03G 1/00**

(30) Priority: **15.05.89 JP 118844/89**

(43) Date of publication of application:
**22.11.90 Bulletin 90/47**

(84) Designated Contracting States:
**DE FR GB IT NL**

(71) Applicant: **MOTOROLA INC.**
**1303 East Algonquin Road**
**Schaumburg Illinois 60196(US)**

(72) Inventor: **Chan, Man**
**1st. F1, DD111 LOT 3228, Off Fan Kan Rd.**
**Ha Che. Nt., Hong Kong(HK)**

(74) Representative: **Holt, Michael et al**
**MOTOROLA European Intellectual Property**
**Operations Jays Close Viables Industrial**
**Estate**
**Basingstoke Hampshire RG22 4PD(GB)**

(54) **An attenuator circuit.**

(57) In an attenuator circuit, a resistor and a variable resistor are coupled in parallel and a node between the resistor and the variable resistor is coupled to a buffer circuit. The resistance of the variable resistor changes in response to a control signal given to the variable resistor so that an attenuation ratio, which is determined by the combined resistance of the resistor and the variable resistor, is established by the control signal. According to the attenuator circuit, a terminal for coupling an external component is omitted.

*FIG. 1*

## An attenuator circuit

### Field of the Invention

This invention refers to an attenuator circuit which attenuates an electrical signal level in response to a predetermined control signal, particularly the circuit is used in an automatic level adjusting circuit which controls the gain of an amplifier circuit in response to an input signal level.

### Background of the Invention

FIG.3 shows an electric block diagram of a prior art automatic level adjusting circuit for explaining a known attenuator circuit. A voice signal picked up by a microphone etc. is applied to an input terminal 10 of the automatic level adjusting circuit. Only an alternating component extracted from this voice signal by AC coupled capacitor 11 is transmitted and applied to one terminal of a resistor 12. The voltage of the voice signal applied to the one terminal is coupled to an attenuator circuit which is constructed of resistor 12, AC bypass capacitor 13, resistor 14 and transistor 15. The voltage provided at the other terminal of resistor 12 is also applied to amplifier circuit 18 through input terminal 17 of integrated circuit 16. An output signal from amplifier circuit 18 is provided at output terminal 19 of integrated circuit 16, and transformed to an acoustic signal by a speaker (not shown).

The output signal from amplifier circuit 18 is applied to a level detection circuit 20. An output signal from level detection circuit 20, for example an output according to an amplitude level of the output signal from amplifier circuit 18 is provided by detecting the envelop of the output signal is applied to the base of transistor 15 and in response to the base voltage the resistance between the collector and emitter changes.

Next, the operation of the above-mentioned attenuator circuit is explained below. The capacity of capacitor 11 is so large that signal attenuation due to capacitor 11 may be negligible at the frequency band used in this automatic level adjusting circuit. Therefore, an attenuation ratio AR, which is the ratio of a signal level applied to input terminal 10 and a signal level provided at input terminal 17, is given by equation (1), where R12 and RI4 are the value of resistor 12 and 14 respectively, Z13 is the impedance of capacitor 13, $R_{ce(15)}$ is the resistance between the collector and emitter of transistor 15 and a symbol "//" means a coupling resistance in parallel connection.

$$AR = \frac{(R14 \; // \; R_{ce(15)}) + Z13}{R12 + (R14 \; // \; R_{ce(15)}) + Z13} \qquad (1)$$

Therefore, the attenuation ratio AR increases as resistance $R_{ce(15)}$ between the collector and emitter of transistor 15 decreases. That is, attenuation ratio AR increases as the signal level applied to input terminal 10 increases.

In the above-mentioned attenuator circuit, capacitor 13 is a bypass capacitor to extract the alternating signal component, and it is equal to or greater than $0.1\mu$F. It is actually impossible to fabricate capacitor 13 on the integrated circuit 16 since a large area is needed. Capacitor 13, therefore, is connected externally through terminal 21 of integrated circuit 16.

Terminal 21 is independently required to connect capacitor 13 off chip. The number of terminals for input and output of signals increases to achieve many functions in integrated circuit 16. Therefore, a circuit which decreases the number of terminals is desirable to enhance the functions of integrated circuit 16.

However, if capacitor 13 is replaced with a direct connection, the DC voltage at the input terminal of amplifier circuit 18 changes because the resistance between the collector and emitter of transistor 15 changes. It is, therefore, impossible to omit capacitor 13 since integrated circuit 16 would have to be operate at a relatively high supply voltage to overcome the effects of the DC component.

It is an object of present invention to provide an attenuator circuit which decreases the number of terminals required in an integrated circuit.

It is a further object of the present invention to operate an integrated circuit including an attenuator circuit at a low supply voltage.

## Summary of the Invention

These and other objects of the present invention will become apparent to those skilled in the art from the present specification.

In order to attain the aforementioned object, this invention comprises a resistor, a variable resistance coupled to the resistor in series and the value of which changes in response to a predetermined control signal and a buffer circuit input of which is coupled to a node of the resistor and the variable resistance, wherein the variable resistance and the buffer circuit are fabricated on a semiconductor integrated circuit.

Further, in this invention, said resistor is fabricated on said semiconductor integrated circuit.

According to this invention, a resistor and a variable resistance are coupled in series. The resistance of the variable resistance changes in response to a predetermined control signal. The signal applied to the resistor is attenuated according to a resistance ratio of the resistor and the variable resistance, and this attenuated signal is applied to a buffer circuit. The variable resistance and the buffer circuit are fabricated on a single semiconductor integrated circuit.

According to this invention, the resistor is further fabricated on the semiconductor integrated circuit.

## Brief Description of the Drawings

FIG. 1 shows an electric block diagram of automatic level adjusting circuit in which an attenuator circuit is used as one embodiment of this invention.

FIG.2 shows a graph which represents a relationship of input and output signal levels in the automatic level adjusting circuit of FIG.1.

FIG.3 shows an electric block diagram of the automatic level adjusting circuit for explaining a known attenuator circuit.

## Detailed Description of the Invention

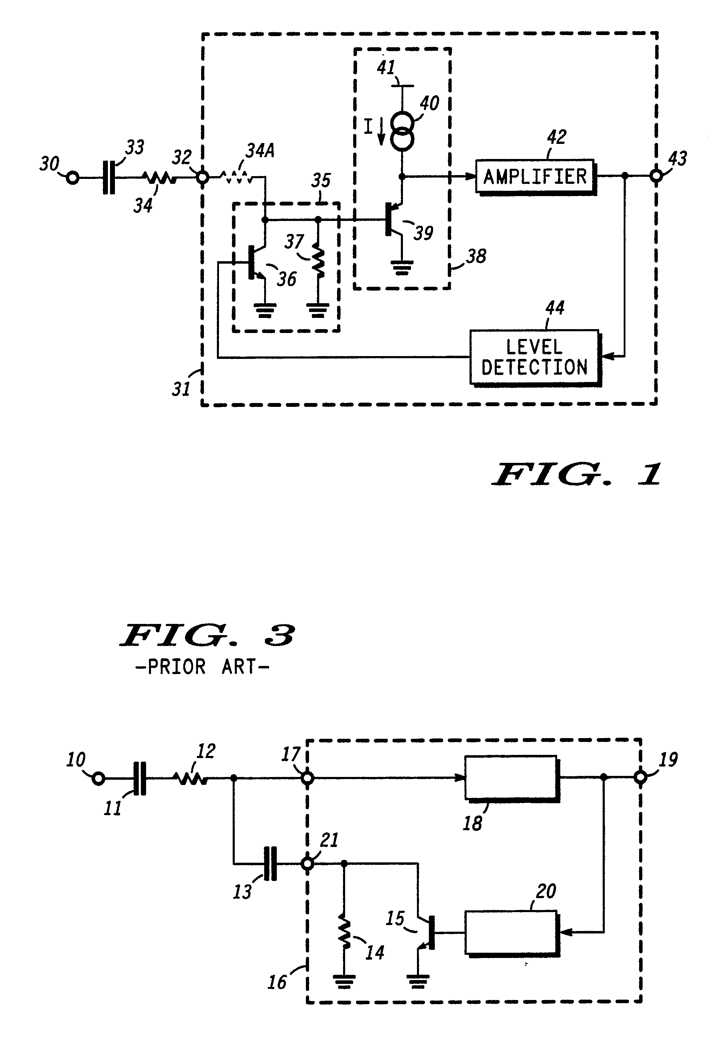

FIG.1 shows an electric block diagram of an automatic level adjusting circuit including an attenuator circuit employing the present invention.

An AC coupling capacitor 33 and a resistor 34 are coupled in series between an input terminal 30 and an input terminal 32 of an integrated circuit 31. Integrated circuit 31 is, for example, a circuit fabricated on a silicon chip. Input terminal 32 is coupled to a variable resistor circuit 35. Variable resistor circuit 35 includes a transistor 36 and a resistor 37. Resistor 37 is coupled in parallel between the collector and emitter of transistor 36. The emitter of transistor 36 is grounded, and the collector thereof is coupled to the base of a transistor 39 which forms a buffer circuit 38. It should be understood that while resistor 34 is illustrated as external to integrated circuit 31, the resistor could be included on integrated circuit 31 as illustrated in broken lines by resistor 34A.

A constant current source 40 in buffer circuit 38 is provided between a source line 41 and the emitter of transistor 39, transistor 39 forms a so-called emitter follower circuit. The collector of transistor 39 is grounded.

The emitter of transistor 39 is coupled to an amplifier circuit 42. An output of amplifier circuit 42 is coupled to an output terminal 43 of integrated circuit 31 and an input of a level detection circuit 44 which detects an output level of amplifier circuit 42. The output signal of level detection circuit 44 is, for instance, obtained by detecting the amplitude of the input signal. The output signal of level detection circuit 44 is applied to the base of transistor 36, and this output signal controls the resistance of variable resistor circuit 35 as a control signal.

The DC component of a signal applied to input terminal 30, for instance a voice signal picked up by microphone etc., is filtered out by capacitor 33, so that only the AC component is provided to the other end of resistor 34. The capacity of capacitor 33 is selected not to attenuate the signal.

The voice signal provided at input terminal 30 is attenuated according to the resistance ratio of resistor 34 and variable resistor circuit 35, and provided to buffer circuit 38. The attenuation ratio AR is given by equation (2), where R34 and R37 are the resistance of resistor 34 and 37 respectively, and $R_{ce(36)}$ is the resistance between the collector and emitter of transistor 36.

$$AR = \frac{R37 \; // \; R_{ce(36)}}{R34 + (R37 \; // \; R_{ce(36)})} \qquad (2)$$

The resistance between the collector and emitter is controlled by the level of the control signal applied to the base, and the resistance of variable resistor circuit 35 is equal to a parallel resistance of the resistance between collector and emitter of transistor 36 and resistor 37.

Constant current source 40 in buffer circuit 38 provides a constant current I to the emitter of transistor 39. A current provided to resistor 37 through the emitter and base of transistor 39 is extremely small so that a voltage generated across resistor 37 is equal to or smaller than 10mV, and it is negligible. Therefore, the voice signal, which is not affected by a bias current due to operation of transistor 36, is transmitted to amplifier circuit 42 through buffer circuit 38 from the output of variable resistor circuit 35.

According to this invention, the DC component in the attenuator circuit is almost zero volts so that the circuit operates at a very low voltage.

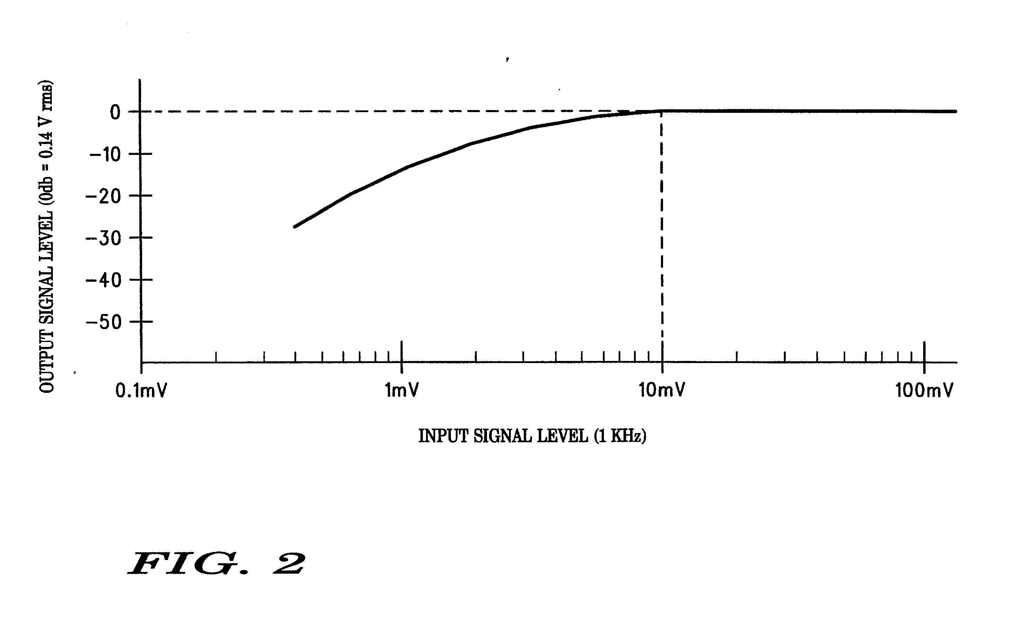

FIG.2 shows a graph which illustrates the relationship of input and output signal levels in the circuit of FIG.1. The horizontal axis represents the AC signal level applied to input terminal 30. The vertical axis represents the output signal level provided at output terminal 43, and 0db is equal to 0.14Vrms. As understood from FIG.2, the output signal level is constant when the input signal level is 10mV and over.

In this embodiment, variable resistor circuit 35, which is formed by transistor 36 and resistor 37 in parallel, is very simple, however, it will be understood by those skilled in the art that any variable resistance which can be controlled by the level of the output signal may be utilized.

Further, buffer circuit 38 is disclosed as an emitter follower circuit in this embodiment, however, ii should be understood that any circuit with a high input impedance may be used.

As mentioned above, a major advantage of the present invention is that the large external capacitor required in prior art attenuator circuit is omitted from the present invention, while still omitting the DC component. Therefore, it is not needed to provide the terminal for the external capacitor on the semiconductor integrated circuit.

Further, the attenuator circuit operates even if the supply voltage provided to the integrated circuit is low.

## Claims

1. An attenuator circuit comprising:
a resistor(34);
a variable resistance(35) coupled to said resistor in series the value of said variable resistance changing in response to a predetermined control signal;
a buffer circuit(38) an input of which is coupled to said resistor(34) and said variable resistance(35);
said variable resistance(35) and said buffer circuit being fabricated on a single semiconductor integrated circuit(31).

2. An attenuator circuit according to claim 1 wherein said resistor(34) is fabricated on said semiconductor integrated circuit(31).

3. An attenuator circuit according to claim 1 including in addition an amplifier(42) having an input coupled to an output of said buffer circuit(38) and an output providing the attenuated output of the attenuator circuit, and a detector(44) having an input coupled to the output of said amplifier(42) and an output coupled to the variable resistance(35) for providing the predetermined control signal.

4. An attenuator circuit according to claim 1 wherein the variable resistance(35) includes a semiconductor device having a control electrode coupled to receive the predetermined control signal and a load resistor coupled to said semiconductor device to provide a variable resistance(35).

5. An attenuator circuit according to claim 4 wherein the semiconductor device is a linear transistor(36) having base,emitter and collector electrodes.

6. An attenuator circuit according to claim 5 wherein the load resistor(37) is connected in parallel with the emitter and collector electrodes.

7. An attenuator circuit according to claim 1 wherein the buffer circuit(38) is a high input impedance emitter follower circuit.

8. An attenuator circuit comprising:

a resistor(34);

a variable resistance(35) coupled to said resistor(34) in series and including a linear transistor having a base electrode coupled to receive a predetermined control signal and an emitter and collector electrodes coupled in parallel with a load resistor to provide a variable resistance(35) the value of said variable resistance changing in response to said predetermined control signal;

a buffer circuit(38) an input of which is coupled to said resistor(34) and said variable resistance(35),and being a high input impedance emitter follower circuit.;

an amplifier(42) having an input coupled to an output of said buffer circuit(38) and an output providing the attenuated output of the attenuator circuit; and detector(44) having an input coupled to the output of said amplifier(42) and an output coupled to the variable resistance(35) for providing the predetermined control signal;

said variable resistance(35), said buffer circuit, said amplifier(42) and said detector(44) being fabricated on a single semiconductor integrated circuit(31).

9. An attenuator circuit according to claim 8 wherein said resistor(34) is fabricated on said semiconductor integrated circuit(31).

5

*FIG. 1*

*FIG. 3*

-PRIOR ART-

*FIG. 2*